(19) Europäisches Patentamt

European Patent Office

Office européen des brevets

(11) **EP 4 700 635 A1**

(12) **EUROPEAN PATENT APPLICATION**

(43) Date of publication:
**25.02.2026 Bulletin 2026/09**

(21) Application number: **25196444.1**

(22) Date of filing: **18.08.2025**

(51) International Patent Classification (IPC):
**G06F 30/20** (2020.01)

(52) Cooperative Patent Classification (CPC):
**G06F 30/20**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **21.08.2024 US 202418810961**

(71) Applicant: **RTX Corporation
Farmington, CT 06032 (US)**

(72) Inventors:
• **ZEIDNER, Lawrence**
  **Farmington (US)**
• **IKEDA, Michael**
  **Farmington (US)**
• **Kodzwa, Paul**
  **Farmington (US)**

(74) Representative: **Dehns
10 Old Bailey
London EC4M 7NG (GB)**

(54) **METHOD FOR DEVELOPING MORE RESILIENT ARCHITECTURES**

(57) A method of developing an architecture including the steps of identifying (200) a plurality of final architectures, identifying (202) a plurality of uncertain elements that will go into each said final architecture, identifying (206), for each of the uncertain elements, a probability that the uncertain element will not be available and identifying a plurality of candidate contingency architectures replacement for each combination of the uncertain elements for each of the final architectures, and identifying (208) a contingency architecture for that architecture and each combination of the uncertain elements not being available, identify (212) an expected value of each said final architecture, wherein the expected value of the final architecture is less than its optimum value and is a probability weighted value.

FIG.4

EP 4 700 635 A1

**Description**

**TECHNICAL FIELD**

This application relates generally to a method of developing system architectures which are more resilient with regard to identifying contingency architectures.

**BACKGROUND OF THE INVENTION**

High-value system architectures are subject to various forms of uncertainty. As one example, architecture elements, such as electronic chips, technologies, suppliers, or manufacturing methods may not be available for production due to supply chain disruptions. System elements involving new, high-risk, high-reward, unproven technology under development, may not become available, with its planned features, because the technology development encounters technical challenges and the technology under-performs. Each system architecture requires a number of distinct elements for manufacture. Coatings, structures, suppliers, and supply delivery are all required and each of these elements are subject to failing. A particular procedure might be identified which is ultimately not achieved. In addition, there are supplier failures, shipping failures and any number of other challenges.

Another type of architecture of interest would involve a course of actions, such as a mission for a military vehicle. While there may be an optimum plan for achieving the mission, there could be occurrences that would make the optimum plan unachievable, such as weather, enemy fire, or equipment failure.

To date, modern design and planning techniques have had difficulty identifying the most resilient architecture based upon available contingent architectures.

**SUMMARY OF THE INVENTION**

In a featured embodiment, a method of developing an architecture including the steps of identifying a plurality of final architectures, identifying a plurality of uncertain elements that will go into each said final architecture, identifying, for each of the uncertain elements, a probability that the uncertain element will not be available and identifying a plurality of candidate contingency architectures replacement for each combination of the uncertain elements for each of the final architectures, and identifying a contingency architecture for that architecture and each combination of the uncertain elements not being available, identify an expected value of each said final architecture, wherein the expected value of the final architecture is less than its optimum value and is a probability weighted value. It will be understood that references to "final architectures" and "feasible architectures" are interchangeable in the context of this disclosure.

In another embodiment according to the previous embodiment, the method relies on a database of computed information for each of the optimum and contingent architectures.

In another embodiment according to any of the previous embodiments, a summation is made for each combination of the uncertain elements in the final architecture, including the product of the optimum value of the best candidate contingency architecture and the probability that the associated combination of uncertain elements is unavailable.

In another embodiment according to any of the previous embodiments, the probability of each of the combinations of uncertain elements is also considered in the summation.

In another embodiment according to any of the previous embodiments, the first final architecture having a lower optimum value than a second said final architecture having a higher optimum value may be selected based upon the higher expected value of the said first final architecture.

In another embodiment according to any of the previous embodiments, the architecture is a mechanical system having a number of interacting components.

In another embodiment according to any of the previous embodiments, the mechanical system is part of an aerospace system.

In another embodiment according to any of the previous embodiments, the system includes a plurality of components and interconnecting flow lines.

In another embodiment according to any of the previous embodiments, the interconnecting flow lines include at least a fluid flow line and an electrical or control flow line.

In another embodiment according to any of the previous embodiments, the uncertain elements include a component in the mechanical system, but the contingency architecture includes a change in one of the interconnecting flow lines.

In another embodiment according to any of the previous embodiments, the mechanical system is then manufactured.

In another embodiment according to any of the previous embodiments, the architecture is a mission plan.

In another embodiment according to any of the previous embodiments, the mission plan is for a military mission, and the mission plan is then performed.

In another embodiment according to any of the previous embodiments, further includes the steps of displaying information indicative of the expected value and the optimum value for each said final architecture.

In another embodiment according to any of the previous embodiments, a first said final architecture having a lower optimum value than a second said final architecture having a higher optimum value may be selected based upon the higher expected value of the said first final architecture.

In another embodiment according to any of the previous embodiments, the architecture is a mechanical system having a number of interacting components.

In another embodiment according to any of the previous embodiments, the mechanical system is then manufactured.

In another embodiment according to any of the previous embodiments, the architecture is a mission plan, which is then performed.

In another featured embodiment, a system for developing an architecture includes one or more processors coupled to memory. The one or more processors collectively operable to execute instructions stored in memory to perform the following, identify a plurality of feasible architectures, identify a plurality of uncertain elements that will go into each said feasible architecture, identify, for each of the uncertain elements, a probability that the uncertain element will not be available and identify contingency architecture for each combination of the uncertain elements in a feasible architecture, and identifying an overall expected value for each said feasible architecture, wherein the expected value is less than an optimum value of the feasible architecture.

In another embodiment according to any of the previous embodiments, the instructions are operable to display information indicative of the expected value and the optimum value of each of the feasible architectures.

The presently claimed invention may include any one or more of the individual features disclosed above and/or below alone or in any combination thereof.

These and other features of the present invention can be best understood from the following specification and drawings, the following of which is a brief description.

## BRIEF DESCRIPTION OF THE DRAWINGS

Figure 1 schematically shows a mechanical system.

Figure 2 shows a problem with modern architectures.

Figure 3 shows a more resilient architecture design.

Figure 4 shows a move from less resilient architectures to the more resilient architectures of the claimed invention.

Figure 5 schematically shows a mission which could be the architecture discussed in this application.

Figure 6 graphically shows a way that a resilient architecture is replaced by a more resilient architecture under the claimed invention.

Figure 7 is a flow chart under this disclosure.

## DETAILED DESCRIPTION

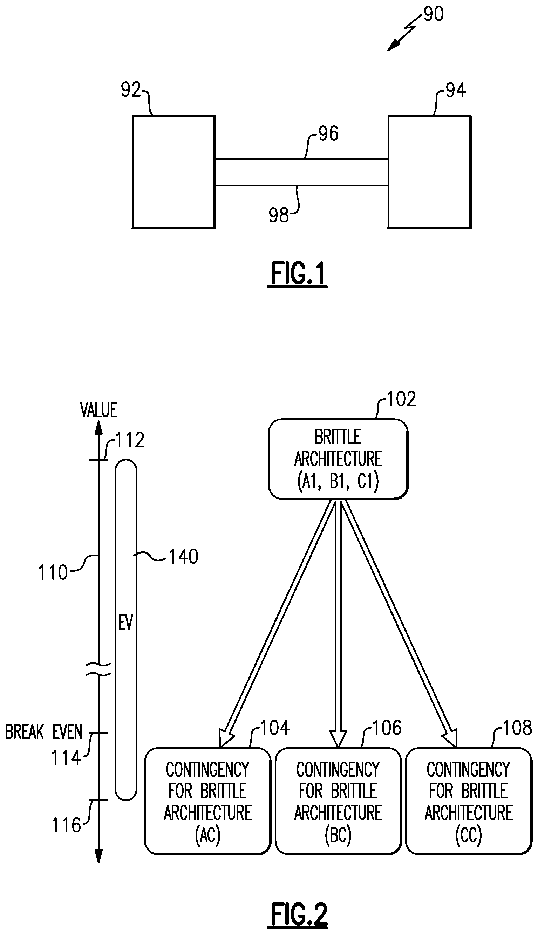

Mechanical system 90 is illustrated in Figure 1 having a first component 92 and a second component 94 connected by flow lines 96 and 98. Line 96 may be a fluid line and line 98 could be an electrical or control connection, or both. Many types of mechanical systems could be system 90. Examples would include fuel systems for a gas turbine engine, variable vanes for a gas turbine engine, or any number of other aerospace systems. And of course systems may have many more components and flow lines. However, it should be understood that architectures beyond aerospace applications could also benefit from the claimed invention.

Figure 2 graphically shows an architecture 102 which could be termed as "brittle." As shown, there may be three uncertain elements A1, B1 and C1 in the brittle architecture. These could include coatings, designs, suppliers, supply lines, technologies, materials or any number of other elements which go into providing the architecture 102. In practice, a worker of skill in this art would recognize there would more likely be dozens if not hundreds of such variables. A subgroup of the variables may be called "uncertain elements" and potentially be unavailable. As an example, there may be a half dozen uncertain elements.

For each of the uncertain elements A1, B1 and C1 there could be a failure. The planned technology may not work. Also, the supplier may prove unreliable. The supply chains may also break down. As an example, with Covid, shipments became unreliable. In addition, requirements could change as one moves closer to a production schedule. Thus, for each of the uncertain elements A1, B1 and C1 there are contingencies (e.g., contingent architectures) 104 AC, 106 BC and 108 CC.

A bar 110 illustrates the value of the architecture as one moves from the ideal "optimum" architecture 102 to the contingencies 104, 106 and 108. As shown at 140 the expected value of the brittle architecture is shown as "EV" along the axis 110, as being somewhere between the optimum value of the brittle architecture (112), and the value of these 3 contingencies 104, 106 and 108 (116), which is far below the optimum value 112, and actually a loss (if any of the uncertain elements A1, B1, or C1 are unavailable) since 116 is lower than the break-even value 114. The Expected Value (EV) is the sum of four products: a) the optimum value [112] times the probability that the brittle architecture can be produced with all uncertain elements available, b) the value of contingency architecture AC (116) times the probability that uncertain element A1 is not available, c) the value of contingency architecture BC (116) times the probability that uncertain element B1 is not available, and d) the value of contingency architecture CC (116) times the probability that uncertain element C1 is not available.

In fact, the values associated with the contingencies 104, 106 and 108 are often below a break even value 114. Break even is defined as when the value equals the (e.g., labor, monetary, etc.) cost of providing the architecture 102. As shown, the values associated with the contingencies 104, 106 and 108 are at a level 116 below the break even value 114, so that they would not be used in the event of unavailability of the associated elements - instead, the product/program would be cancelled at a significant loss. This is what is meant by a brittle architecture - high risk / high reward.

Setbacks do occur, and if a setback occurs with the brittle architecture 102, the result could be very unsatisfactory.

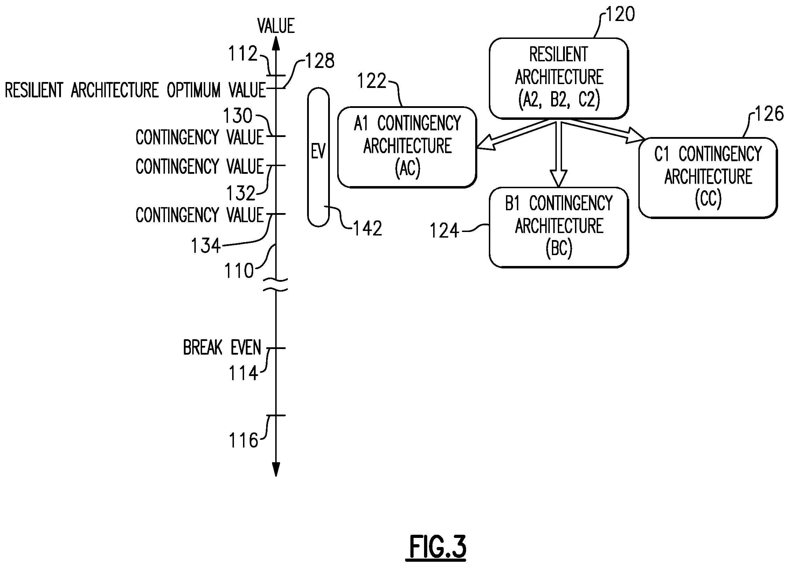

Figure 3 shows a resilient architecture. Workers in the art also refer to the resilience or the resiliency of an architecture. Here, the resilient architecture 120 has an optimum value 128 on bar 110 that may be below the optimum value 112 of the brittle architecture 102 (Figure 2). However, the value of the resilient architecture's contingencies 122 AC and 124 BC and 126 CC are far above the break even value 114, and even further above the value 116 of the contingencies 104, 106 and 108 for the brittle architecture 102. As shown at 142 the drop from optimum value 128 is not as pronounced as the drop 140 in Figure 2.

It could be said the resilient architecture 120 may have uncertain elements, like the brittle architecture 102, however, the value of their contingencies, when key uncertain elements cannot be used, are acceptable. Thus, the resilient architecture 120 may be the best choice. The elements may include choices of different components, different subassemblies, different system-architecture structure (network of technology options and their interconnecting flows), different suppliers, different manufacturing processes, different software architectures, etc.

It should be understood that contingency is not necessarily related to just the components including the uncertain elements. As an example, if an element of component 92 becomes unavailable, that could necessitate a change to component 92 to produce it without the missing element, a change to component 94, to provide the associated functionality for which the missing element was responsible, and possibly a change to the flow lines 96 or 98, e.g., to communicate necessary material, power, or information to the updated component 94, to constitute the contingency architecture.

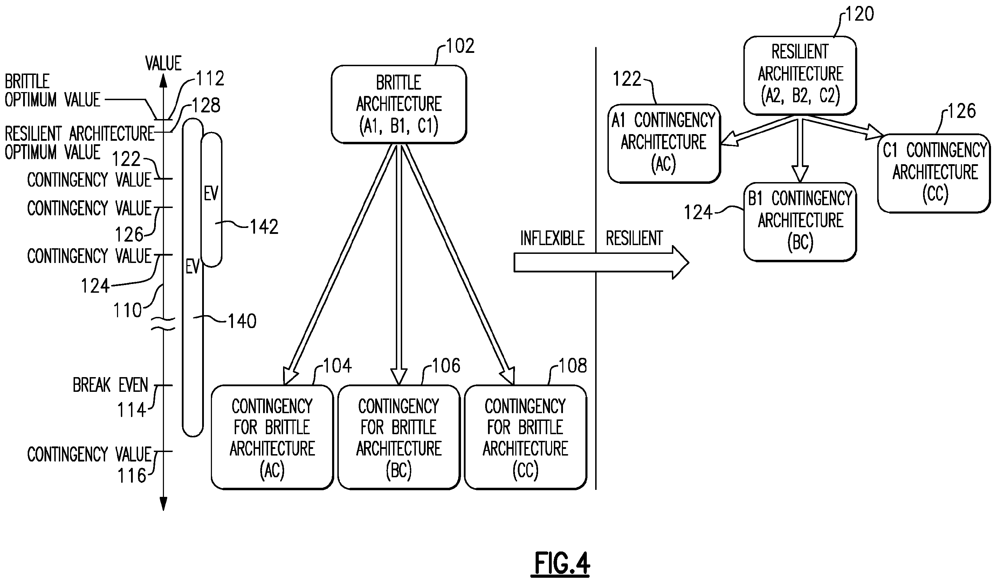

Figure 4 contrasts the brittle architecture 102 versus the more resilient architecture 120. It also shows the range of potential expected value for the brittle architecture 140, when relying on the contingencies 104, 106, and 108, versus the range of potential expected value for the resilient architecture 142, when relying on the contingencies 122, 124, and 126. The expected value of brittle architecture 102 is somewhere along bar 140, and is likely much lower than the expected value of resilient architecture 120, which is somewhere along bar 142.

This disclosure recognizes that while the optimum value 112 of the brittle architecture 102 may be higher than the optimum value 128 of the resilient architecture 120, it may be prudent to rely on the resilient architecture 120, recognizing that contingencies will likely become necessary, and the expected value 142 is much better than the expected value 140. Given the probabilities of all relevant events, the expected value is what is actually expected; while the optimum value is only actually expected if there are no uncertain elements to the architecture.

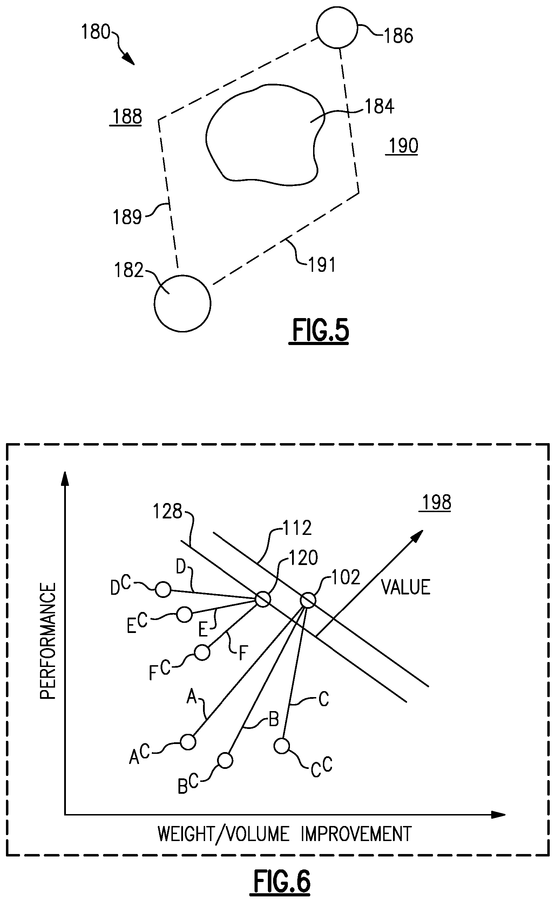

Figure 5 shows an alternative type architecture 180 wherein the teachings of this method are not applied to a system, but rather to a mission, such as a route (e.g., flight) plan. Assume an aircraft 182 needs to reach a destination 186, but there is a mountain 184 in the way. A flight plan may be designed at 189 to move to the left 188 of the mountain 184, or to the right 190 on flight plan 191. Flight plan 191 may be optimum, however, there may be contingent variables such as hostile activity for a military mission, or bad weather, on side 190. Those uncertain events may make the flight plan 189 actually more resilient than the flight plan 191, even though the flight plan 189 may be less optimum in that it would be longer.

When applied to missions or campaigns, the architectural elements involve resources (troops, platforms, munitions, etc.), courses of action, and their temporal and spatial embodiments. Uncertainty in combat is ever present, so resilient orders, missions, campaigns have higher expected value than brittle ones, though the optimum value of the brittle ones may be somewhat higher, if they actually succeed intact.

Figure 6 graphically shows the method of the claimed invention. The most optimum architecture 102, which is brittle, has total optimum value 112. However, as shown, the A, B and C uncertain elements have very low contingent values AC, BC and CC. Contrast this to the resilient architecture 120 having the optimum value 128. Although optimum value 128 may be below optimum value 112 the contingencies for uncertain elements D, E and F are much higher in value at DC, EC and FC. Although these values were listed as A, B and C in Figures 3 and 4, D, E and F are used here to assist the reader in understanding the contrast. Thus, it may be advisable to select the architecture 120, compared to the architecture 102. It should be understood, with regard to all of the contingencies, there would be a probability that an uncertain element becomes unavailable, and a drop in the expected value of architecture 120, to use its contingency architecture. The values and probabilities are based upon historic information and perhaps a realistic approximation of achievability.

In fact, a computer associated with this system will display an image 198 with the information shown in Figure 6.

For each feasible architecture the components and flows are identified. One identifies optimum component and flow sizing and attributes. A value is identified as a function of a set of value metrics (e.g., cost, weight, reliability, efficiency). A probability is identified for each of the uncertain elements, indicating the likelihood they would be available. Note that these probabilities could be about the components or flows becoming unavailable, but they could just as easily be about manufacturing processes, transportation vehicles, suppliers, etc.

An algorithm under this method identifies an expected value for each of the high value architectures. For each architecture and its components and flows, the expected value equals a dot product of the probabilities of each combination of uncertain elements being unavailable, and the value of the best associated contingency architecture available in each such case.

Algorithm:

　　◦ For each of the highest-value architectures:
　　◦ For each combination of that architecture's components and flows: comb(c&f):
　　◦ Identify CA = the best contingency architecture if that combination of components & flows is unavailable
　　◦ Where there are multiple possible ways to define "best"
　　◦ For example:
　　◦ "best" = highest optimum value
　　◦ "best" = least architectural change vs. arch

$$\text{Expected value}(\text{architecture})$$

$$= \sum_{comb(c\&f)} (prob(comb(c\&f)\ unavailability) * value(CA))$$

The architecture with the highest expected value is the most resilient architecture, which together with its set of contingency architectures, weathers various possible expected storms.

Utilizing this formula for computing the expected value, one may identify the most resilient architecture, which might not have the highest upside or optimum value of a brittle architecture, however, the resilient architecture is most likely to be achieved successfully with the highest expected value.

Notably, architectures defined within this disclosure would include not only systems as shown in Figure 1, but also operational methods such as shown in Figure 5.

The methods may be achieved by a system having appropriate computing structure incorporating processing circuitry.

Processing circuitry (e.g., control or computing device) may include one or more computer processors, memory, storage means, network devices, input and/or output devices, and/or interfaces. The control may be operable to execute one or more software programs. The control may be programmed with one or more instructions to execute any of the functionality disclosed herein. The control may be operable to communicate with one or more networks established by one or more computing devices. The memory may include UVPROM, EEPROM, FLASH, RAM, ROM, DVD, CD, a hard drive, or other computer readable medium which may store data and/or the functionality of this description. The control may be a desktop computer, laptop computer, smart phone, tablet, or any other computer device. Input devices may include a keyboard, mouse, touchscreen, etc. The output devices may include a monitor, speakers, printers, etc. The display 198 may be on such a monitor. The control may include one or more processors coupled to memory. The computing devices may be coupled to each other by one or more connections. The connection may be a wired and/or wireless connection. The connection may be established over one or more networks and/or other computing systems. In particular, the control may communicate with various internal systems including manufacturing machines and/or external (e.g., customer, supplier, etc.) systems such as various databases and other information stores. In implementations, the control may be operable to communicate with one or more onboard and/or offboard systems suitable for conducting mission planning (e.g., geography, weather conditions, etc.).

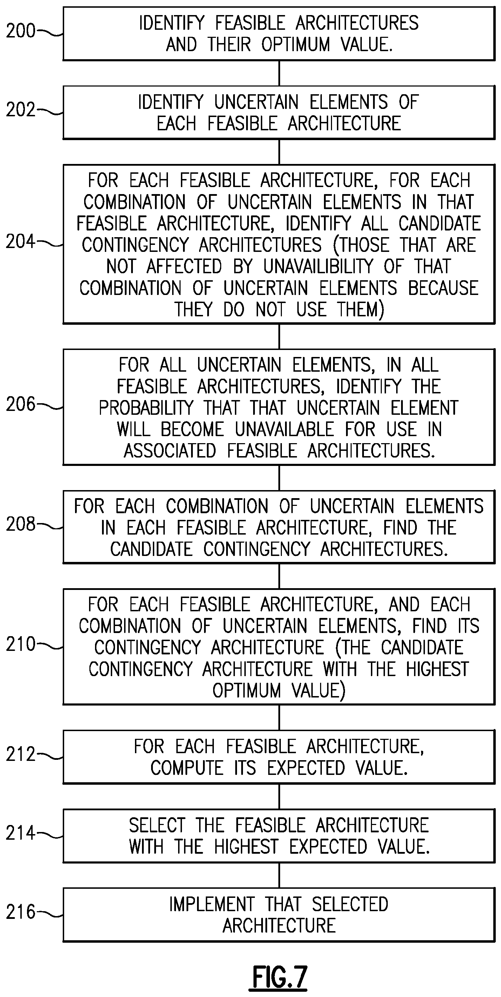

A flow chart describing the method of the claimed invention is illustrated in Figure 7. At step 200 many feasible architectures are identified. An optimal "value" for each architecture is also identified.

At step 202 each uncertain element of each feasible architecture is identified.

At step 204, for each feasible architecture, all combinations of its uncertain elements are considered. For each combination of uncertain elements, find all contingency (fallback) architectures - these are architectures that are immune to that combination of uncertain elements being unavailable, because they do not include those uncertain elements.

At step 206 the method identifies an independent probability of unavailability of each uncertain element.

At step 208, for each feasible architecture, and each combination of its uncertain elements, the candidate contingency architectures, when that combination of uncertain elements is unavailable - are all of the architectures that can substitute for the feasible architecture due to the combination of uncertain elements being unavailable. This is because the candidate contingency architectures do not include any of the uncertain elements in that combination.

At step 210, for each feasible architecture, and each combination of its uncertain elements being unavailable, the contingency architecture is the associated candidate contingency architecture with the highest optimum value.

At step 212, for each feasible architecture, its expected value is computed as the dot product of the probabilities for each of the combinations of its uncertain elements being unavailable, and the corresponding optimum value of the contingency architectures associated with those combinations of uncertain elements being unavailable. One also includes the case in which all uncertain elements are available.

At step 214, select the feasible architecture with the highest expected value.

At step 216, implement the selected architecture. That selected architecture may include manufacturing a mechanical system should the method be the Figure 1 embodiment. On the other hand, step 216 can also be met by performing a mission such as the Figure 5 mission.

Ultimately, the final step in the method would be to actually manufacture the system 90 of Figure **1,** or perform the mission 180 of Figure 5.

A method of developing an architecture under the claimed invention could be said to include the steps of identifying a plurality of final architectures, identifying a plurality of uncertain elements that will go into each said final architecture, identifying, for each of the uncertain elements, a probability that the uncertain element will not be available, identifying a plurality of candidate contingency architectures for each combination of the uncertain elements for each of the final architectures, and identifying a contingency architecture for that architecture and each combination of uncertain elements not being available, wherein an expected value of that architecture is less than its optimum value, and is a probability-weighted value.

A system for developing an architecture under the claimed invention could be said to include one or more processors coupled to memory. The one or more processors are collectively operable to execute instructions stored in memory to perform the following: identify a plurality of feasible architectures, identify a plurality of uncertain elements that will go into each said feasible architecture, identify, for each uncertain element, a probability that the uncertain element will not be available, identify a contingency architecture for each combination of the uncertain elements in a feasible architecture, and identify an overall expected value for each said feasible architecture, wherein the expected value is less than an optimum value of the feasible architecture.

The instructions are operable to display information indicative of the expected value and the optimum value of each of the feasible architectures.

A worker of skill in this art would recognize that modifications would come within the scope of the claimed invention. For that reason, the following claims should be studied to determine the true scope and content of this invention.

**Claims**

1. A method of developing an architecture comprising the steps of:

   identifying (200) a plurality of feasible architectures;
   identifying (202) a plurality of uncertain elements that will go into each feasible architecture;
   identifying (206), for each of the uncertain elements, a probability that the uncertain element will not be available; and
   identifying (208) a plurality of candidate contingency architectures replacement for each combination of the uncertain elements for each of the feasible architectures, and identifying a contingency architecture for that architecture and each combination of the uncertain elements not being available, identify (212) an expected value of each feasible architecture, wherein the expected value of the feasible architecture is less than its optimum value and is a probability weighted value.

2. The method as set forth in claim 1, wherein the method relies on a database of computed information for each of the optimum and contingent architectures.

3. The method as set forth in claim 1 or claim 2, wherein a summation is made for each combination of the uncertain elements in the feasible architecture, including a product of the optimum value of the best candidate contingency architecture and the probability that the associated combination of uncertain elements is unavailable.

4. The method as set forth in claim 3, wherein the probability of each of the combinations of uncertain elements is also considered in the summation.

5. The method as set forth in any of the preceding claims, wherein a first feasible architecture having a lower optimum value than a second feasible architecture having a higher optimum value may be selected based upon the higher expected value of the first feasible architecture.

6. The method as set forth in any of the preceding claims, wherein the architecture is a mechanical system (90) having a number of interacting components.

7. The method as set forth in claim 6, wherein the mechanical system (90) is part of an aerospace system.

8. The method as set forth in claim 6 or claim 7, wherein the mechanical system (90) includes a plurality of components and interconnecting flow lines (96, 98), and optionally wherein the interconnecting flow lines include at least a fluid flow line (96) and an electrical or control flow line (98).

9. The method as set forth in claim 8, wherein the uncertain elements include a component in the mechanical system (90), but the contingency architecture includes a change in one of the interconnecting flow lines (96, 98).

10. The method as set forth in any of claims 6-9, wherein the mechanical system (90) is then manufactured.

11. The method as set forth in any of claims 1-5, wherein the architecture is a mission plan (180) and optionally wherein the mission plan is then performed.

12. The method as set forth in claim 11, wherein the mission plan (180) is for a military mission.

13. The method as set forth in any of the preceding claims, further including the steps of displaying information indicative of the expected value and the optimum value for each feasible architecture.

14. A system for developing an architecture comprising:
one or more processors coupled to memory, the one or more processors collectively operable to execute instructions stored in memory to perform the following:

identify (200) a plurality of feasible architectures;
identify (202) a plurality of uncertain elements that will go into each feasible architecture;
identify (206), for each of the uncertain elements, a probability that the uncertain element will not be available; and
identify (208) contingency architecture for each combination of the uncertain elements in a feasible architecture, and identifying (212) an overall expected value for each feasible architecture, wherein the expected value is less than an optimum value of the feasible architecture.

15. The system as set forth in claim 14, wherein the instructions are operable to display information indicative of the expected value and the optimum value of each of the feasible architectures.

90

92    94

96

98

## FIG.1

VALUE

112

110    140

EV

BREAK EVEN

114

116

102

BRITTLE
ARCHITECTURE
(A1, B1, C1)

104    106    108

CONTINGENCY
FOR BRITTLE
ARCHITECTURE
(AC)

CONTINGENCY
FOR BRITTLE
ARCHITECTURE
(BC)

CONTINGENCY
FOR BRITTLE
ARCHITECTURE
(CC)

## FIG.2

FIG.3

FIG.4

EP 4 700 635 A1

**FIG.5**

**FIG.6**

200 — IDENTIFY FEASIBLE ARCHITECTURES AND THEIR OPTIMUM VALUE.

202 — IDENTIFY UNCERTAIN ELEMENTS OF EACH FEASIBLE ARCHITECTURE

204 — FOR EACH FEASIBLE ARCHITECTURE, FOR EACH COMBINATION OF UNCERTAIN ELEMENTS IN THAT FEASIBLE ARCHITECTURE, IDENTIFY ALL CANDIDATE CONTINGENCY ARCHITECTURES (THOSE THAT ARE NOT AFFECTED BY UNAVAILIBILITY OF THAT COMBINATION OF UNCERTAIN ELEMENTS BECAUSE THEY DO NOT USE THEM)

206 — FOR ALL UNCERTAIN ELEMENTS, IN ALL FEASIBLE ARCHITECTURES, IDENTIFY THE PROBABILITY THAT THAT UNCERTAIN ELEMENT WILL BECOME UNAVAILABLE FOR USE IN ASSOCIATED FEASIBLE ARCHITECTURES.

208 — FOR EACH COMBINATION OF UNCERTAIN ELEMENTS IN EACH FEASIBLE ARCHITECTURE, FIND THE CANDIDATE CONTINGENCY ARCHITECTURES.

210 — FOR EACH FEASIBLE ARCHITECTURE, AND EACH COMBINATION OF UNCERTAIN ELEMENTS, FIND ITS CONTINGENCY ARCHITECTURE (THE CANDIDATE CONTINGENCY ARCHITECTURE WITH THE HIGHEST OPTIMUM VALUE)

212 — FOR EACH FEASIBLE ARCHITECTURE, COMPUTE ITS EXPECTED VALUE.

214 — SELECT THE FEASIBLE ARCHITECTURE WITH THE HIGHEST EXPECTED VALUE.

216 — IMPLEMENT THAT SELECTED ARCHITECTURE

FIG.7

Europäisches
Patentamt

European
Patent Office

Office européen
des brevets

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2006/135417 A2 (BOEING CO [US]; BUTTERFIELD MARION L [US] ET AL.) 21 December 2006 (2006-12-21) * the whole document * | 1-15 | INV. G06F30/20 |
| A | WO 00/22552 A1 (SIEMENS AG [DE]; THOME BERNHARD [DE]; ROSENBERGER MATTHIAS [DE]) 20 April 2000 (2000-04-20) * abstract; figure 2 * | 1-15 | |
| A | US 2007/260436 A1 (COURETAS JERRY M [US] ET AL) 8 November 2007 (2007-11-08) * abstract; figure 5 * | 1-15 | |
| A | INDIKA MEEDENIYA ET AL: "Robust ArcheOpterix: Architecture optimization of embedded systems under uncertainty", SOFTWARE ENGINEERING FOR EMBEDDED SYSTEMS (SEES), 2012 2ND INTERNATIONAL WORKSHOP ON, IEEE, 9 June 2012 (2012-06-09), pages 23-29, XP032195765, DOI: 10.1109/SEES.2012.6225486 ISBN: 978-1-4673-1852-5 * abstract * | 1-15 | **TECHNICAL FIELDS SEARCHED (IPC)** G06F |

-/--

The present search report has been drawn up for all claims

| Place of search | Date of completion of the search | Examiner |
|---|---|---|
| Munich | 26 November 2025 | Weidmann, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

**Application Number**

EP 25 19 6444

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | INDIKA MEEDENIYA ET AL: "Architecture-driven reliability optimization with uncertain model parameters", JOURNAL OF SYSTEMS & SOFTWARE, ELSEVIER NORTH HOLLAND, NEW YORK, NY, US, vol. 85, no. 10, 23 April 2012 (2012-04-23), pages 2340-2355, XP028401180, ISSN: 0164-1212, DOI: 10.1016/J.JSS.2012.04.056 [retrieved on 2012-05-07] * abstract * ----- | 1-15 | |
| A | KELLY GRIENDLING ET AL: "An architecture-based approach to identifying system-of-systems alternatives", SYSTEM OF SYSTEMS ENGINEERING (SOSE), 2010 5TH INTERNATIONAL CONFERENCE ON, IEEE, PISCATAWAY, NJ, USA, 22 June 2010 (2010-06-22), pages 1-6, XP031729258, ISBN: 978-1-4244-8197-2 * abstract * ----- | 1-15 | TECHNICAL FIELDS SEARCHED (IPC) |

The present search report has been drawn up for all claims

| Place of search | Date of completion of the search | Examiner |
|---|---|---|
| Munich | 26 November 2025 | Weidmann, Matthias |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 25 19 6444

This annex lists the patent family members relating to the patent documents cited in the above-mentioned European search report.
The members are as contained in the European Patent Office EDP file on
The European Patent Office is in no way liable for these particulars which are merely given for the purpose of information.

26-11-2025

| Patent document cited in search report | | Publication date | Patent family member(s) | | Publication date |
|---|---|---|---|---|---|
| WO 2006135417 | A2 | 21-12-2006 | EP | 1789872 A2 | 30-05-2007 |
| | | | EP | 2221720 A1 | 25-08-2010 |
| | | | US | 2006064178 A1 | 23-03-2006 |
| | | | US | 2009018806 A1 | 15-01-2009 |
| | | | WO | 2006135417 A2 | 21-12-2006 |
| WO 0022552 | A1 | 20-04-2000 | NONE | | |
| US 2007260436 | A1 | 08-11-2007 | NONE | | |

EPO FORM P0459

For more details about this annex : see Official Journal of the European Patent Office, No. 12/82